# EUROPÄISCHE PATENTANMELDUNG

(11) **EP 4 835 928 A1**
(43) Veröffentlichungstag der Anmeldung: **04.11.2026**
(21) Anmeldenummer: 25173703.7
(22) Anmeldetag: 30.04.2025
(51) Int. Cl.: H01F 27/06, H01F 27/29, H01F 27/32, H05K 1/18, H05K 3/30, H05K 3/36

(54) **TRANSFORMATOR ZUR LEITERPLATTENMONTAGE UND SYSTEM UMFASSEND EINEN TRANSFORMATOR ZUR LEITERPLATTENMONTAGE**

(71) Anmelder: Siemens Aktiengesellschaft, 80333 München (DE)
(72) Erfinder: Rothmayer, Thomas, 1140 Wien (AT)
(74) Vertreter: Siemens Patent Attorneys

(57) **Zusammenfassung**

Die Erfindung betrifft einen Transformator (1) zur Leiterplattenmontage, umfassend:
- einen Magnetkern (2);
- einen am Magnetkern (2) angeordneten Spulenkörper (3);
- eine erste Wicklung (4) und zumindest eine zweite Wicklung (5), welche am Spulenkörper (3) angeordnet sind;
- eine am Transformator (1) angeordnete Gruppe von elektrischen Anschlüssen (6, 7, 8, 9), umfassend einen ersten (6), einen zweiten (7), einen dritten (8) und einen vierten Anschluss (9);
- wobei der erste (6) und der zweite Anschluss (7) mit der ersten Wicklung (4) verbundenen sind;
- wobei der dritte (8) und der vierte Anschluss (9) mit der zweiten Wicklung (5) verbundenen sind; und
- wobei sich zumindest der erste Anschluss (6) derart in einem ersten Winkel ungleich 0° zu einem anderen Anschluss aus der Gruppe der Anschlüsse (7, 8, 9) erstreckt, dass der Transformator (1) über die Gruppe von Anschlüssen (6, 7, 8, 9) an zumindest zwei Leiterplatten (18, 19) elektrisch anschließbar ist, welche in unterschiedlichen Ebenen liegen, die sich in einem zweiten Winkel ungleich 0° schneiden.

## Beschreibung

Die Erfindung betrifft einen Transformator zur Leiterplattenmontage sowie ein System umfassend einen Transformator zur Leiterplattenmontage.

Aus dem Stand der Technik bekannt sind Transformatoren zur Leiterplattenmontage, welche lediglich zur Montage an einer einzelnen Leiterplatte geeignet sind.

Ein Nachteil von derartigen Transformatoren ist, dass deren Anschlüsse nahe beieinander liegen. Damit wird eine vom Transformator, insbesondere von den Wicklungen, über die Anschlüsse auf die Leiterplatte übertragene Wärme in einem kleinen Bereich der Leiterplatte konzentriert. Dies führt zu thermischen Problemen auf der Leiterplatte. Außerdem sind unterschiedliche Wicklungen von Transformatoren üblicherweise Bestandteile von Schaltungsteilen, welche bevorzugt räumlich möglichst getrennt voneinander auf einer Leiterplatte ausgebildet sind. Dies ist durch nahe beieinanderliegende Anschlüsse erschwert.

Die Aufgabe der Erfindung ist es daher, einen Transformator bereitzustellen, welcher eine größere Freiheit beim Entwurf von Leiterplatten erlaubt und thermische Probleme auf Leiterplatten verhindert.

Die Aufgabe wird gelöst durch einen Transformator zur Leiterplattenmontage, umfassend:
- einen Magnetkern;
- einen am Magnetkern angeordneten Spulenkörper;
- eine erste Wicklung und zumindest eine zweite Wicklung, welche am Spulenkörper angeordnet sind;
- eine am Transformator angeordnete Gruppe von elektrischen Anschlüssen, umfassend einen ersten, einen zweiten, einen dritten und einen vierten Anschluss;
- wobei der erste und der zweite Anschluss mit der ersten Wicklung verbundenen sind;
- wobei der dritte und der vierte Anschluss mit der zweiten Wicklung verbundenen sind; und
- wobei sich zumindest der erste Anschluss derart in einem ersten Winkel ungleich 0° zu einem anderen Anschluss aus der Gruppe der Anschlüsse erstreckt, dass der Transformator über die Gruppe von Anschlüssen an zumindest zwei Leiterplatten elektrisch anschließbar ist, welche in unterschiedlichen Ebenen liegen, die sich in einem zweiten Winkel ungleich 0° schneiden.

Dieser Transformator erlaubt eine besondere Freiheit beim Entwurf der Leiterplatten, weil damit die Anschlusspunkte für die Anschlüsse des Transformators auf unterschiedlichen Leiterplatten platziert werden können. Damit kann beispielsweise ein mit der ersten Wicklung verbundener erster Schaltungsteil auf einer ersten Leiterplatte und ein mit der zweiten Wicklung verbundener zweiter Schaltungsteil auf einer zweiten Leiterplatte platziert werden. Dies ist vorteilhaft im Hinblick auf Luft- und Kriechstrecken sowie elektromagnetische Verträglichkeit (EMV).

Der Transformator erlaubt eine besonders vorteilhafte räumliche getrennte Anordnung der Anschlusspunkte für die Anschlüsse. Damit kann die von den Wicklungen ausgehende Wärme an unterschiedlichen Bereichen von unterschiedlichen Leiterplatten verteilt werden.

Mit dem Transformator ist außerdem eine Platzierung der Aus- oder Einleitung von Signalen über die Anschlüsse genau dort möglich, wo die Signale auf den Leiterplatten verarbeitet werden. Damit ist der Transformator in besonderer Weise für Hochfrequenz-Anwendungen geeignet, da aufwändige Leiterbahnen für Hochfrequenz-Signale vermieden werden können.

Die Montage an zwei Leiterplatten erlaubt es außerdem, dass der Transformator von den Leiterplatten in einer Normalrichtung zu den Leiterplatten beabstandet anordenbar ist, ohne mechanisch anfällig für Rüttel- oder Schockkräfte zu sein. Dadurch ist unterhalb des Transformators Platz für die Montage von Bauteilen auf den Leiterplatten. Außerdem ist der Transformator damit beabstandet von einem Gehäuse, was vorteilhaft ist, da somit keine oder weniger Wirbelströme im Gehäuse erzeugt werden.

Die Aufgabe wird weiter gelöst durch ein System, umfassend:
- einen erfindungsgemäßen Transformator,
- eine erste Leiterplatte und eine zweite Leiterplatte,
- wobei die erste und die zweite Leiterplatte in unterschiedlichen Ebenen liegen, die sich in einem zweiten Winkel ungleich 0° schneiden, und
- wobei der Transformator über die Gruppe von Anschlüssen mit der ersten und der zweiten Leiterplatte verbunden ist.

Das System weist alle Vorteile des erfindungsgemäßen Transformators auf. Das System hat außerdem eine kompakte Bauweise sowie eine optimierte Ausgestaltung im Hinblick auf Wärmeausleitung, EMV und Verlustleistung.

Vorteile und Ausgestaltungen der Erfindung, die einzeln oder in Kombination miteinander einsetzbar sind, sind Gegenstand der Unteransprüche.

Für den Transformator ist es vorteilhaft, wenn sich der zweite oder der dritte Anschluss in die gleiche Richtung erstreckt wie der erste Anschluss. Bevorzugt ist es, wenn sich der zweite Anschluss in die gleiche Richtung erstreckt wie der erste Anschluss. Durch diese Maßnahme kann die erste Wicklung ausschließlich mit der ersten Leiterplatte und die zweite Wicklung ausschließlich mit der zweiten Leiterplatte verbunden werden. Damit kann beispielsweise ein Primärstromkreis auf der einen und ein Sekundärstromkreis auf der anderen Leiterplatte realisiert werden. Wenn sich der dritte Anschluss in die gleiche Richtung erstreckt wie der erste Anschluss erlaubt das weitere Freiheiten beim Entwurf der Leiterplatten oder anderer umgebender Komponenten.

Vorteilhaft ist es, wenn der erste und der zweite Winkel jeweils im Wesentlichen rechte Winkel sind. Durch diese Maßnahme wird eine besonders kompakte Anordnung der Komponenten erreicht.

Vorteilhaft ist es, wenn die Anschlüsse am Spulenkörper angeordnet sind. Durch diese Maßnahme wird der Transformator besonders einfach herstellbar.

Vorteilhaft ist es, wenn die Anschlüsse durch Enden der Wicklungen gebildet sind. Wenn die Anschlüsse durch die Enden der Wicklungen gebildet sind, hat das den Vorteil, dass durch die Flexibilität der Wicklungen keine Kraft auf die Lötstellen ausgeübt wird.

Vorteilhaft ist es, wenn die Anschlüsse zur Durchsteckmontage ausgebildet sind. Durch diese Maßnahme können in besonders vorteilhafter Weise die Enden der Wicklungen als Anschlüsse verwendet werden, was die Herstellung des Transformators vereinfacht.

Vorteilhaft ist es, wenn die erste und/oder die zweite Wicklung eine HF-Litze umfasst. Dadurch wird ein Einsatz des Transformators für Hochfrequenz-Anwendungen ermöglicht. Außerdem ist die Freiheit der Platzierung der Anschlüsse besonders bei HF-Anwendungen vorteilhaft, weil bei HF-Anwendungen kurze Wege auf Leiterplatten vorteilhaft sind. Die erste und/oder die zweite Wicklung kann auch jeweils aus einer HF-Litze ausgeführt sein.

Vorteilhaft ist es, wenn der Transformator weiters ein erstes Montagemittel zur Montage des Transformators, insbesondere an einer ersten oder zweiten Leiterplatte, umfasst, wobei das erste Montagemittel eine erste Montagerichtung aufweist, die sich in die gleiche Richtung erstreckt wie der erste Anschluss oder der zweite Anschluss.

Außerdem ist es vorteilhaft, wenn der Transformator weiters ein zweites Montagemittel umfasst, wobei das zweite Montagemittel eine zweite Montagerichtung aufweist, die sich in die gleiche Richtung erstreckt wie der dritte Anschluss oder der vierte Anschluss.

Mit anderen Worten ist es vorteilhaft, wenn der Transformator ein erstes Montagemittel mit einer ersten Montagerichtung und ein zweites Montagemittel mit einer zweiten Montagerichtung umfasst, wobei sich die erste Montagerichtung des ersten Montagemittels derart in einem ersten Winkel ungleich 0° zur zweiten Montagerichtung des zweiten Montagemittels erstreckt, dass der Transformator über das erste und das zweite Montagemittel an zumindest zwei Leiterplatten montierbar ist, welche in unterschiedlichen Ebenen liegen, die sich in einem zweiten Winkel ungleich 0° schneiden.

Die Montagerichtung ist die Richtung, in welcher der Transformator mit einer der Leiterplatten verbunden wird. Beispielsweise kann der Transformator zuerst an einer ersten Leiterplatte montiert werden und anschließend an einer zweiten Leiterplatte, wobei gleichzeitig die erste Leiterplatte an der zweiten Leiterplatte montiert wird oder die beiden Leiterplatten miteinander verbunden werden. Die Leiterplatten können über eine Steck- oder Lötverbindung miteinander verbunden werden.

Vorteilhaft ist es, wenn der Transformator weiters ein erstes Anpressmittel umfasst, über welches vom Transformator eine Anpresskraft ausübbar ist. Die Anpresskraft kann beispielsweise auf eine erste oder zweite Leiterplatte ausgeübt werden. Die erste oder zweite Leiterplatte kann damit ihrerseits auf einen Isolator und dieser an einen Kühlkörper angepresst werden. Damit wird in vorteilhafter Weise ein Wärmeübergang von einer Leiterplatte auf den Kühlkörper erreicht. Ein separates Bauteil zum Erzeugen der Anpresskraft wird eingespart, da die Anpresskraft vom Anpressmittel des Transformators erzeugt wird. Der Transformator kann weiters ein zweites, drittes, viertes oder weitere Anpressmittel umfassen, über welche vom Transformator eine Anpresskraft auf die erste und/oder die zweite Leiterplatte ausübbar ist. In allen Ausführungsformen kann ein Anpressmittel bevorzugt in der Umgebung eines Montagemittels, insbesondere am Transformator oder am Spulenkörper, angeordnet sein.

In einer bevorzugten Ausführungsform umfasst der Transformator ein zweites Anpressmittel, über welches vom Transformator eine Anpresskraft ausübbar ist. In einer weiteren bevorzugten Ausführungsform umfasst der Transformator ein erstes und ein zweites Montagemittel sowie ein erstes und ein zweites Anpressmittel. Damit ist der Transformator an eine erste und eine zweite Leiterplatte montierbar und es ist eine Anpresskraft sowohl auf eine erste als auch auf eine zweite Leiterplatte ausübbar.

Vorteilhaft ist es, wenn der Transformator weiters ein erstes Montagemittel zur Montage des Transformators an einem Kühlkörper und ein erstes Anpressmittel umfasst, wobei über das erste Montagemittel eine erste Kraft auf das erste Anpressmittel ausübbar ist, sodass das erste Anpressmittel eine, zur ersten Kraft im Wesentlichen gleichgerichtete, zweite Kraft auf die erste Leiterplatte ausübt. Vorteilhaft ist es außerdem, wenn der Transformator weiters ein zweites Montagemittel zur Montage des Transformators an einem Kühlkörper und ein zweites Anpressmittel umfasst, wobei über das zweite Montagemittel eine dritte Kraft auf das zweite Anpressmittel ausübbar ist, sodass das zweite Anpressmittel eine, zur dritten Kraft im Wesentlichen gleichgerichtete, vierte Kraft auf die zweite Leiterplatte ausübt. Durch diese Maßnahmen wird erreicht, dass Kräfte auf die Leiterplatten ausübbar sind, welche die Leiterplatten über zwischengeordnete Elemente wie bspw. Isolatoren auf andere Elemente wie bspw. einen Kühlkörper gepresst werden können. Dadurch wird ein Wärmeübergang von den Leiterplatten über Isolatoren auf den Kühlkörper erreicht.

Vorteilhaft ist es, wenn die zweite Kraft oder ggf. die vierte Kraft direkt auf die erste Leiterplatte oder ggf. die zweite Leiterplatte ausübbar ist. Durch diese Maßnahme üben die Anpresselemente eine Kraft direkt auf die Leiterplatten aus. Damit können weite Bereiche der Leiterplatten angepresst werden und die Kraft auf einen weiten Bereich verteilt werden. Außerdem ist diese Maßnahme toleranter für Bauteiltoleranzen.

Vorteilhaft ist es, wenn die zweite Kraft oder ggf. die vierte Kraft auf ein auf der ersten Leiterplatte oder ggf. auf ein auf der zweiten Leiterplatte angeordnetes elektronisches Bauteil ausübbar ist. Durch diese Maßnahme werden Bauteile auf die Leiterplatten gepresst und indirekt Kraft auf die Leiterplatten ausgeübt. Dadurch wird der Wärmeübergang des elektronischen Bauteils auf die Leiterplatte verbessert.

Außerdem ist es vorteilhaft, wenn die Montagemittel und/oder die Anpressmittel durch den Spulenkörper ausgebildet sind. Dadurch ist der Transformator besonders effizient herstellbar.

Vorteilhaft ist es, wenn eine elektrische Kontaktierung der Leiterplatten über den Spulenkörper geführt ist. Damit kann auf einfache Weise eine elektrische Verbindung zwischen den Leiterplatten hergestellt werden.

Für das System ist es vorteilhaft, wenn es einen Transformator,
umfassend ein erstes Montagemittel zur Montage des Transformators, wobei das erste Montagemittel eine erste Montagerichtung aufweist, die sich in die gleiche Richtung erstreckt wie der erste Anschluss oder der zweite Anschluss,
umfasst, wobei der Transformator über das erste Montagemittel mit der ersten Leiterplatte verbunden ist. Die Verbindung kann dabei kraftschlüssig und/oder eine formschlüssig ausgeführt sein. Eine formschlüssige Verbindung kann ausgeführt sein, indem das erste Montagemittel in eine Bohrung der ersten Leiterplatte eingeführt ist. Das erste Montagemittel kann durch die erste Leiterplatte hindurchragen.

Außerdem ist es vorteilhaft, wenn das System einen Transformator,
umfassend ein zweites Montagemittel, wobei das zweite Montagemittel eine zweite Montagerichtung aufweist, die sich in die gleiche Richtung erstreckt wie der dritte Anschluss oder der vierte Anschluss,
umfasst, wobei der Transformator über das zweite Montagemittel mit der zweiten Leiterplatte verbunden ist. Die Verbindung kann dabei kraftschlüssig und/oder eine formschlüssig ausgeführt sein. Eine formschlüssige Verbindung kann ausgeführt sein, indem das zweite Montagemittel in eine Bohrung der zweite Leiterplatte eingeführt ist. Das zweite Montagemittel kann durch die zweite Leiterplatte hindurchragen.

Vorteilhaft ist es, wenn das System einen Transformator,
umfassend ein erstes Anpressmittel, über welches vom Transformator eine Anpresskraft ausübbar ist,
umfasst, wobei vom ersten Anpressmittel eine Anpresskraft auf die erste Leiterplatte wirksam ist. Damit kann in vorteilhafter Weise ein separates Bauteil zum Anpressen der Leiterplatte eingespart werden. Außerdem ist es vorteilhaft, wenn das System einen Transformator mit einem zweiten Anpressmittel umfasst, über welches vom Transformator eine Anpresskraft ausübbar ist, wobei vom zweiten Anpressmittel eine Anpresskraft auf die zweite Leiterplatte wirksam ist.

Vorteilhaft ist es, wenn das System weiters einen Isolator umfasst, der zwischen der ersten Leiterplatte und einem Kühlkörper eingeklemmt ist. Damit kann in vorteilhafter Weise Wärme von der ersten Leiterplatte über den Isolator an den Kühlkörper abgegeben werden. Besonders bevorzugt ist die Kombination dieses Merkmals mit dem ersten Anpressmittel. Bei dieser Kombination kann das erste Anpressmittel und der Isolator jeweils an gegenüberliegenden Seiten eines gleichen Bereichs der erste Leiterplatte angeordnet sein. Dadurch wird die Klemmung des Isolators und damit der Wärmeübergang von der ersten Leiterplatte auf den Kühlkörper verbessert. Der Kühlkörper kann in allen Ausführungsformen als Gehäuse ausgeführt sein bzw. das Gehäuse kann in allen Ausführungsformen als Kühlkörper ausgeführt sein.

Außerdem ist es vorteilhaft, wenn das System weiters einen Kühlkörper umfasst, wobei der Transformator über das erste Montagemittel oder ggf. das zweite Montagemittel mit dem Kühlkörper verbunden ist. Dadurch wird eine besonders kompakte Bauweise des Systems erreicht. In einer Ausführungsvariante kann der Kühlkörper durch ein Gehäuse, ein Gehäuseteil, eine Isolierschalte oder einen anderen Teil des Systems ersetzt sein. Der Kühlkörper kann alternativ auch gleichzeitig ein Gehäuse oder ein Gehäuseteil bilden.

Vorteilhaft ist es, wenn das erste Montagemittel oder ggf. das zweite Montagemittel durch die erste Leiterplatte oder die zweite Leiterplatte ragt. Dadurch wird eine besonders kompakte Bauweise erreicht.

Vorteilhaft ist es, wenn das System weiters einen Isolator umfasst, welcher zwischen dem Kühlkörper und der ersten und/oder der zweiten Leiterplatte angeordnet ist, und durch welchen Wärme von der ersten und/oder der zweiten Leiterplatte auf den Kühlkörper übertragbar ist. Dadurch wird ein optimaler und sicherer Wärmeübergang von einer Leiterplatte auf den Kühlkörper erreicht.

Im Folgenden wird die Erfindung anhand der in den Figuren dargestellten Ausführungsbeispiele näher beschrieben und erläutert.
Figur 1 zeigt eine erste Ansicht eines Ausführungsbeispiels eines erfindungsgemäßen Transformators,
Figur 2 zeigt eine erste Ansicht eines Ausführungsbeispiels eines erfindungsgemäßen Systems,
Figur 3 zeigt eine zweite Ansicht eines Ausführungsbeispiels eines erfindungsgemäßen Systems, und
Figur 4 zeigt eine Schnitt-Ansicht eines Ausführungsbeispiels eines erfindungsgemäßen Systems.

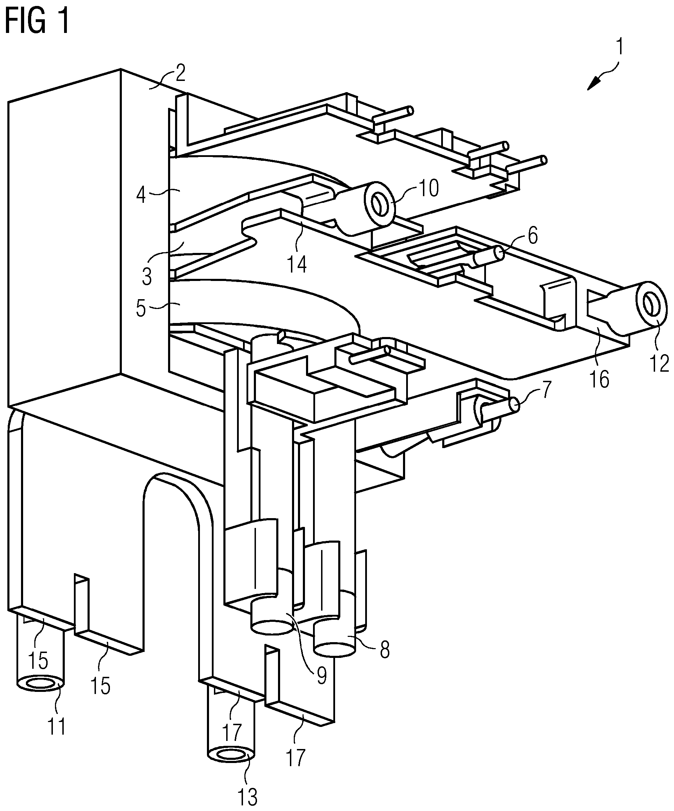

Fig. 1 zeigt eine erste Ansicht eines Ausführungsbeispiels eines erfindungsgemäßen Transformators 1 zur Leiterplattenmontage, umfassend einen Magnetkern 2, einen am Magnetkern angeordneten Spulenkörper 3, eine erste Wicklung 4 und eine zweite Wicklung 5, welche am Spulenkörper 3 angeordnet sind. Weiters dargestellt ist eine am Transformator angeordnete Gruppe von elektrischen Anschlüssen, umfassend einen ersten Anschluss 6, einen zweiten Anschluss 7, einen dritten Anschluss 8 und einen vierten Anschluss 9. Der erste Anschluss 6 und der zweite Anschluss 7 sind mit der ersten Wicklung 4 verbundenen. Der dritte Anschluss 8 und der vierte Anschluss 9 sind mit der zweiten Wicklung 5 verbundenen. In diesem Ausführungsbeispiel erstrecken sich der erste Anschluss 6 und der zweite Anschluss 7 in einem ersten Winkel von im Wesentlichen 90° zum dritten Anschluss 8 und zum vierten Anschluss 9. Damit ist der Transformator 1 an zwei Leiterplatten elektrisch anschließbar, welche in unterschiedlichen Ebenen liegen, die sich in einem zweiten Winkel von im Wesentlichen 90° schneiden. Mit anderen Worten ist der Transformator 1 an zwei Leiterplatten elektrisch anschließbar, welche im Wesentlichen in einem rechten Winkel zueinanderstehen. "Im Wesentlichen 90°" und "im Wesentlichen in einem rechten Winkel" stehen in diesem Zusammenhang für einen Bereich von 85°-95°. Der erste Winkel und der zweite Winkel können in anderen Ausführungsformen auch beispielsweise in einem Bereich von 10°-170° liegen, insbesondere 30°-150°, bevorzugt 50°-130°, besonders bevorzugt 70°-110°, äußerst bevorzugt 85°-95°.

In diesem Ausführungsbeispiel sind die Anschlüsse 6, 7, 8, 9 als Anschlüsse zur Durchsteckmontage ausgeführt. Die Anschlüsse 6, 7, 8, 9 können aber auch als Anschlüsse zur Oberflächenmontage (englisch: surface-mounting technology, SMT) ausgeführt werden. In diesem Ausführungsbeispiel sind die Anschlüsse 6, 7, 8, 9 am Spulenkörper 3 angeordnet.

Der Spulenkörper 3 kann bspw. mit einem additiven Fertigungsverfahren, z.B. Laser-Sintern, oder mit einem Spritzgussverfahren hergestellt werden.

Der Spulenkörper 3 umfasst in diesem Ausführungsbeispiel weiters ein erstes Montagemittel 10, ein zweites Montagemittel 11, ein drittes Montagemittel 12 und ein viertes Montagemittel 13. Die Montagemittel 10, 11, 12, 13 sind in diesem Ausführungsbeispiel als Aufnahmen für Montageelemente, bspw. Schrauben, Nieten oder einrastende Stifte, ausgeführt. Bevorzugt ist die Ausführung als Aufnahmen für Schrauben. Dazu können die Aufnahmen Gewinde aufweisen, bspw. indem Gewinde in die Aufnahmen eingespritzt sind, oder es können Schrauben verwendet werden, die sich in das Material der Aufnahmen einschneiden.

Die Montagemittel 10, 11, 12, 13 dienen zur Montage des Transformators 1 an anderen Komponenten, bspw. einem Kühlkörper, einem Gehäuse, einem Gehäuseteil, einer Leiterplatte. Die Montagemittel 10, 11, 12, 13 wirken mit Anpressmittel 14, 15, 16, 17 zusammen. Das heißt, dass bspw. der Transformator ein erstes Montagemittel, bspw. zur Montage des Transformators an einem Kühlkörper, und ein erstes Anpressmittel umfasst, wobei über das erste Montagemittel eine erste Kraft auf das erste Anpressmittel ausübbar ist, sodass das erste Anpressmittel eine, zur ersten Kraft im Wesentlichen gleichgerichtete, zweite Kraft auf die erste Leiterplatte ausübt. Die Montagemittel 10, 11, 12, 13 weisen in diesem Ausführungsbeispiel in unterschiedliche Richtungen.

Mit anderen Worten kann der Transformator 1 über eines oder mehrere der Montagemittel 10, 11, 12, 13 an einer Anordnung montiert werden, wobei die Anordnung bspw. einen Kühlkörper, ein Gehäuse, ein Gehäuseteil oder eine Leiterplatte umfasst. Die Montage ist kraft- oder formschlüssig. Die Montage ist dabei so ausgelegt, dass eine Presspassung eines der Anpressmittel 14, 15, 16, 17 mit einer der Leiterplatten auftritt. Eines oder mehrere der Anpressmittel 14, 15, 16, 17 drücken damit auf eine oder beide Leiterplatten.

In diesem Ausführungsbeispiel werden die Anschlüsse 6, 7, 8, 9 durch die Wicklungen 4, 5 gebildet. Dazu sind die Drähte der Wicklungen 4, 5 beispielsweise verzinnt, wenn sie aus Litzen bestehen. Bei einer Ausführung mit Einzel-Drähten kann das Wicklungsende vom Spulenkörper 3 abstehen. Eine weitere Möglichkeit ist, dass Anschlusskontakte, bspw. in Form von Pins, am Spulenkörper 3 vorhanden sind, welche mit den Wicklungen 4, 5 verbunden sind.

Der Spulenkörper 3 kann in einem Ausführungsbeispiel für Toleranzausgleich und Flexibilität optimiert sein. Dabei sind flexible Elemente integriert, um die mechanische Toleranz und Anpassungsfähigkeit zu verbessern. Im Bereich der Montageposition wird eine erhöhte Konfiguration implementiert, die verlängerte "Stelzen" als toleranzausgleichende Strukturelemente nutzt. Zur Verbesserung der Flexibilität kommen flexible Leitungen bzw. Drähte zu den Anschlüssen 8, 9 zum Einsatz, während die Kunststoff-Stützbeine mit gezielter Flexibilität ausgestattet werden. Ein "akkordeonartiger" Mechanismus in den Beinen erhöht zusätzlich die Bewegungsabsorption und Nachgiebigkeit. Die Drahtführung wird durch die Einbringung kleiner Bewegungsschlaufen optimiert. Dabei wird die Geometrie des Spulenkörpers so modifiziert, dass diese Bewegungsschlaufen während des Wickelprozesses gezielt geführt und ermöglicht werden. Die Konstruktionsziele umfassen die Verbesserung der mechanischen Toleranz, die Erhöhung der Anpassungsfähigkeit an Maßabweichungen, die Reduzierung der Belastung elektrischer Verbindungen sowie die Vereinfachung des Herstellungsprozesses.

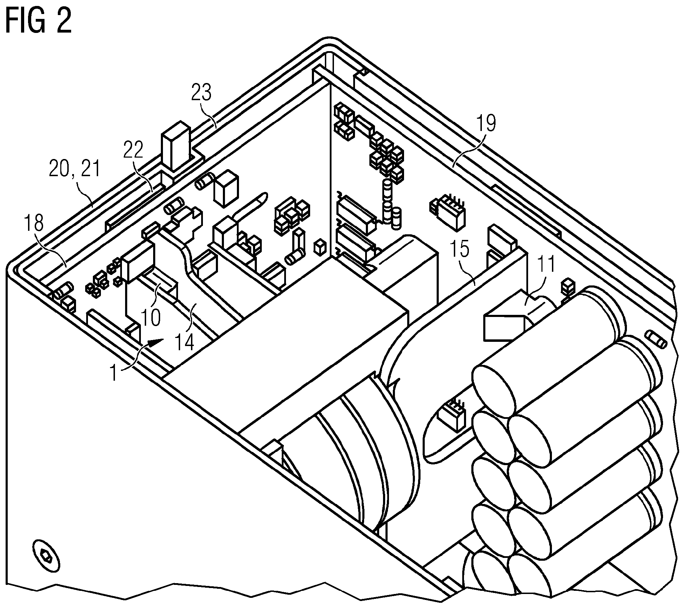

Fig. 2 zeigt eine erste Ansicht eines Ausführungsbeispiels eines erfindungsgemäßen Systems. Einzelne, das System umgebende, Gehäuseteile sind nicht dargestellt. Dargestellt ist der Transformator 1, eine erste Leiterplatte 18 und eine zweite Leiterplatte 19. Die erste Leiterplatte 18 und die zweite Leiterplatte 19 liegen in unterschiedlichen Ebenen, die sich in einem zweiten Winkel ungleich 0° schneiden. In diesem Ausführungsbeispiel beträgt der zweite Winkel 90°. Mit anderen Worten stehen die erste Leiterplatte 18 und die zweite Leiterplatte 19 in einem rechten Winkel zueinander. Der Transformator 1 ist über die Gruppe von Anschlüssen 6, 7, 8, 9 mit der ersten Leiterplatte 18 und der zweiten Leiterplatte 19 verbunden.

Dargestellt sind außerdem das erste Montagemittel 10, das zweite Montagemittel 11, das erste Anpressmittel 14 und das zweite Anpressmittel 15. Der Transformator 1 ist in diesem Ausführungsbeispiel über das erste Montagemittel 10 und das zweite Montagemittel 11 mit einem Kühlkörper 20 verschraubt, der gleichzeitig ein Gehäuse 21 ausbildet. Das erste Montagemittel 10 und das zweite Montagemittel 11 ragen in dieser Ausführungsform jeweils durch die erste Leiterplatte 18 und die zweite Leiterplatte 19 hindurch. Durch die Verbindung des ersten Montagemittels 10 und des zweiten Montagemittels 11 mit dem Kühlkörper 20 wird jeweils das erste Anpressmittel 14 an die erste Leiterplatte 18 und das zweite Anpressmittel 15 an die zweite Leiterplatte 19 angepresst. Das hat zur Folge, dass eine Pressung zwischen dem Kühlkörper 20 bzw. dem Gehäuse 21 auf der einen Seite und jeweils der ersten Leiterplatte 18 und der zweiten Leiterplatte 19 auf der anderen Seite hergestellt wird. Dadurch haben zwischen dem Kühlkörper 20 bzw. dem Gehäuse 21 auf der einen Seite und jeweils der ersten Leiterplatte 18 und der zweiten Leiterplatte 19 auf der anderen Seite angeordnete Isolatoren 22 einen beidseitigen Kontakt und können in besonders vorteilhafter Weise einen Wärmeübergang zwischen jeweils der ersten Leiterplatte 18 und der zweiten Leiterplatte 19 auf der anderen Seite und dem Kühlkörper 20 bzw. dem Gehäuse 21 auf der einen Seite herstellen. Wärme, welche durch auf den Leiterplatten vorhandene Bauteile erzeugt wird, gelangt über Vias auf jeweils die andere Seite der Leiterplatte und wird von dort über die Isolatoren 22 abgeführt. Die Isolatoren 22 sind elektrisch isolierend und thermisch konduktiv ausgeführt. Die Isolatoren 22 können in allen Ausführungsbeispielen als Keramikisolatoren ausgeführt sein.

Dargestellt ist außerdem, dass in einer Normalrichtung auf die Leiterplatten 18, 19 gesehen unter dem Transformator 1 elektronische Bauteile, insbesondere Halbleiter-Bauelemente und Leistungshalbleiter-Bauelemente, angeordnet sind. Die Bereiche der Leiterplatten 18, 19, in denen die elektronischen Bauteile angeordnet sind, werden über die Anpresselemente 14, 15, 16, 17 an die Isolatoren 22 gepresst. Die Isolatoren 22 sind dabei direkt unter den elektronischen Bauteilen angeordnet. Der Wärmeübergang durch die Leiterplatten 18, 19 wird durch Vias verbessert. Durch die Anordnung der elektronischen Bauteile unter dem Transformator 1 wird eine optimale Ausnutzung der Leiterplattenfläche erreicht. Alternativ ist es auch möglich, dass die Anpresselemente 14, 15, 16, 17 auf die elektronischen Bauteile wirken. Dadurch werden die Leiterplatten 18, 19 indirekt über die elektronischen Bauteile gegen die Isolatoren 22 gepresst.

Die Montagemittel 10, 11, 12, 13, in diesem Ausführungsbeispiel als Schraubdome ausgeführt, sind in Bohrungen in den Leiterplatten 18, 19 eingesetzt. Zwischen den Leiterplatten 18, 19 und dem Gehäuse 20, 21 befinden sich unterhalb der elektronischen Bauteile Isolatoren 22. Mittels Montageelementen, in diesem Ausführungsbeispiel als Schrauben ausgeführt, wird der Transformator 1, insbesondere der Spulenkörper 3, an den Montagemitteln an das Gehäuse 20, 21 gepresst. Am Transformator 1, insbesondere am Spulenkörper 3, befinden sich Anpressmittel 14, 15, 16, 17, ausgeführt in diesem Beispiel als Stege, die neben den elektronischen Bauteilen auf die Leiterplatte oder die Leiterplatten 18, 19 drücken und somit die Leiterplatte oder die Leiterplatten 18, 19 mit dem Isolator 22 an das Gehäuse 20, 21 pressen.

Der Transformator 1 ist durch den hoch aufragenden Spulenkörper 3 mit den Wicklungen 4, 5 ausreichend weit beabstandet von dem Gehäuse 20, 21, wo durch Wirbelströme zusätzliche Verluste entstehen könnten.

Der Transformator 1 kann mit seinem Magnetkern 2 so nahe am Gehäuse 20, 21 platziert werden, dass der Magnetkern 2 über ein wärmeleitendes Element, beispielsweise eine Isolierung oder ein Pad, thermisch mit dem Gehäuse 20, 21 verbunden und damit gekühlt wird. Der Transformator 1 kann mittels Schrauben, die in den Spulenkörper 3 ragen, gegen das Gehäuse 20, 21 gespannt sein, beispielsweise von außen nach innen geschraubt oder von innen geschraubt oder geclipst.

Der Transformator 1 wird in diesem Beispiel zuerst über den ersten und den zweiten Anschluss 6, 7 in die erste Leiterplatte 18 eingelötet. Anschließend wird die erste Leiterplatte 18 in die zweite Leiterplatte 19 eingelötet und der dritte und der vierte Anschluss 8, 9 verlötet.

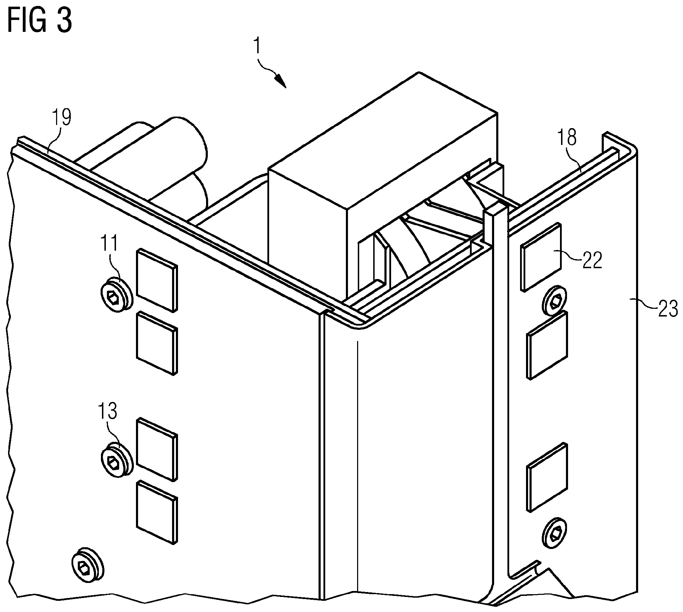

Fig. 3 zeigt eine zweite Ansicht eines Ausführungsbeispiels eines erfindungsgemäßen Systems. Der Kühlkörper 20 und das Gehäuse 21 sind dabei nicht dargestellt. Dargestellt ist, wie die Montagemittel 10, 11, 12, 13 durch die Leiterplatte 18, 19 und teilweise auch durch die Isolierschale 23 ragen. Dargestellt sind weiters die Isolatoren 22, welche in der Isolierschale 23 eingelegt sind.

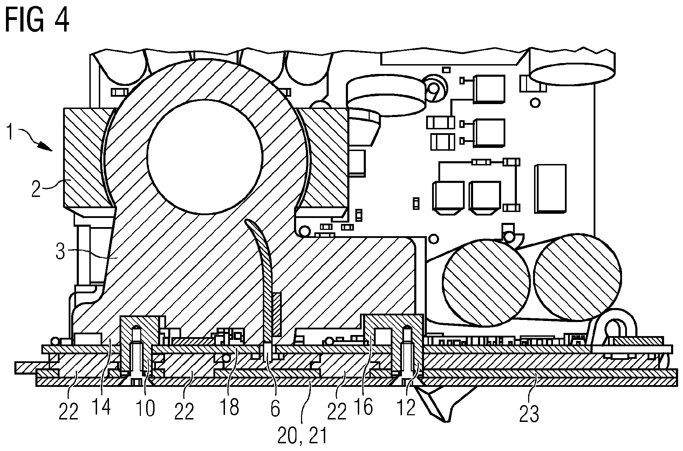

Figur 4 zeigt eine Schnitt-Ansicht eines Ausführungsbeispiels eines erfindungsgemäßen Systems. Dargestellt ist, wie Isolatoren 22 zwischen dem Kühlkörper 20, der in diesem Beispiel ein Gehäuse 21 ist, und der ersten Leiterplatte 18 angeordnet sind. Die Isolatoren 22 sind eingeklemmt. Dadurch gewährleisten sie einen optimalen Wärmeübergang von der Leiterplatte auf den Kühlkörper 20. Eingeklemmt werden sie dadurch, dass die Anpressmittel, in dieser Darstellung das erste Anpressmittel 14 und das dritte Anpressmittel 16 die Leiterplatte zum Kühlkörper 20 pressen. Dies wird erreicht, indem die Montagemittel, in dieser Darstellung das erste Montagemittel 10 und das dritte Montagemittel 12, mit Montageelementen, in dieser Ausführungsform mit Schrauben, am Kühlkörper 20 bzw. am Gehäuse 21 montiert werden.

Der in Fig. 4 dargestellte rechte Teil des Spulenkörpers 3, der an den als Zylinder dargestellten Elektrolyt-Kondensator angrenzt, kann in einem anderen Ausführungsbeispiel weiter auskragen, um den Elektrolyt-Kondensator gegen Rütteln abzufangen.

### Bezugszeichenliste

- 1: Transformator
- 2: Magnetkern
- 3: Spulenkörper
- 4: Erste Wicklung
- 5: Zweite Wicklung
- 6: Erster Anschluss
- 7: Zweiter Anschluss
- 8: Dritter Anschluss
- 9: Vierter Anschluss
- 10: Erstes Montagemittel
- 11: Zweites Montagemittel
- 12: Drittes Montagemittel
- 13: Viertes Montagemittel
- 14: Erstes Anpressmittel
- 15: Zweites Anpressmittel
- 16: Drittes Anpressmittel
- 17: Viertes Anpressmittel
- 18: Erste Leiterplatte
- 19: Zweite Leiterplatte
- 20: Kühlkörper
- 21: Gehäuse
- 22: Isolator
- 23: Isolierschale

## Patentansprüche

1. Transformator (1) zur Leiterplattenmontage, umfassend:
- einen Magnetkern (2);
- einen am Magnetkern (2) angeordneten Spulenkörper (3);
- eine erste Wicklung (4) und zumindest eine zweite Wicklung (5), welche am Spulenkörper (3) angeordnet sind;
- eine am Transformator (1) angeordnete Gruppe von elektrischen Anschlüssen (6, 7, 8, 9), umfassend einen ersten (6), einen zweiten (7), einen dritten (8) und einen vierten Anschluss (9);
- wobei der erste (6) und der zweite Anschluss (7) mit der ersten Wicklung (4) verbundenen sind;
- wobei der dritte (8) und der vierte Anschluss (9) mit der zweiten Wicklung (5) verbundenen sind; und
- wobei sich zumindest der erste Anschluss (6) derart in einem ersten Winkel ungleich 0° zu einem anderen Anschluss aus der Gruppe der Anschlüsse (7, 8, 9) erstreckt, dass der Transformator (1) über die Gruppe von Anschlüssen (6, 7, 8, 9) an zumindest zwei Leiterplatten (18, 19) elektrisch anschließbar ist, welche in unterschiedlichen Ebenen liegen, die sich in einem zweiten Winkel ungleich 0° schneiden.

2. Transformator (1) nach Anspruch 1, wobei sich der zweite (7) oder der dritte Anschluss (8) in die gleiche Richtung erstreckt wie der erste Anschluss (6).

3. Transformator (1) nach einem der vorangehenden Ansprüche, wobei der erste und der zweite Winkel jeweils im Wesentlichen rechte Winkel sind.

4. Transformator (1) nach einem der vorangehenden Ansprüche, wobei die Anschlüsse (6, 7, 8, 9) am Spulenkörper (3) angeordnet sind.

5. Transformator (1) nach einem der vorangehenden Ansprüche, wobei die Anschlüsse (6, 7, 8, 9) durch Enden der Wicklungen (4, 5) gebildet sind.

6. Transformator (1) nach einem der vorangehenden Ansprüche, wobei die Anschlüsse (6, 7, 8, 9) zur Durchsteckmontage ausgebildet sind.

7. Transformator (1) nach einem der vorangehenden Ansprüche, wobei die erste (4) und/oder die zweite Wicklung (5) eine HF-Litze umfasst.

8. Transformator (1) nach einem der vorangehenden Ansprüche, weiters umfassend ein erstes Montagemittel (10) zur Montage des Transformators (1), wobei das erste Montagemittel (10) eine erste Montagerichtung aufweist, die sich in die gleiche Richtung erstreckt wie der erste Anschluss (6) oder der zweite Anschluss (7).

9. Transformator (1) nach Anspruch 8, weiters umfassend ein zweites Montagemittel (11), wobei das zweite Montagemittel (11) eine zweite Montagerichtung aufweist, die sich in die gleiche Richtung erstreckt wie der dritte Anschluss (8) oder der vierte Anschluss (9).

10. Transformator (1) nach einem der vorangehenden Ansprüche, weiters umfassend ein erstes Anpressmittel (14), über welches vom Transformator (1) eine Anpresskraft ausübbar ist.

11. System, umfassend:
- einen Transformator (1) nach einem der Ansprüche 1 bis 10,
- eine erste Leiterplatte (18) und eine zweite Leiterplatte (19),
- wobei die erste (18) und die zweite Leiterplatte (19) in unterschiedlichen Ebenen liegen, die sich in einem zweiten Winkel ungleich 0° schneiden, und
- wobei der Transformator (1) über die Gruppe von Anschlüssen (6, 7, 8, 9) mit der ersten (18) und der zweiten Leiterplatte (19) verbunden ist.

12. System nach Anspruch 11, umfassend einen Transformator (1) nach Anspruch 8, wobei der Transformator (1) über das erste Montagemittel (10) mit der ersten Leiterplatte (18) verbunden ist.

13. System nach Anspruch 12, umfassend einen Transformator (1) nach Anspruch 9, wobei der Transformator (1) über das zweite Montagemittel (11) mit der zweiten Leiterplatte (19) verbunden ist.

14. System nach einem der Ansprüche 11 bis 13, umfassend einen Transformator (1) nach Anspruch 10, wobei vom ersten Anpressmittel (14) eine Anpresskraft auf die erste Leiterplatte (18) wirksam ist.

15. System nach Anspruch 14, weiters umfassend einen Isolator (22), der zwischen der ersten Leiterplatte (18) und einem Kühlkörper (20) eingeklemmt ist.
